# FASCICULE DE BREVET EUROPEEN

(11) **EP 4 483 193 B1**
(45) Date de publication et mention de la délivrance du brevet: **28.01.2026**
(21) Numéro de dépôt: 22847547.1
(22) Date de dépôt: 15.12.2022
(51) Int. Cl.: G01R 31/36, G01R 31/50, G01R 31/00, G01R 19/165

(54) **PROCEDE DE DIAGNOSTIC D'UN DEFAUT DE DECONNEXION D'UN STOCKEUR ELECTRIQUE DE SECURITE DANS UN RESEAU ELECTRIQUE DE BORD D'UN VEHICULE ELECTRIFIE**
VERFAHREN ZUR DIAGNOSE EINES ABSCHALTFEHLERS IN EINEM NOT-UP-STROMSPEICHER IN EINEM BORDNETZ EINES ELEKTROFAHRZEUGS
METHOD FOR DIAGNOSING A DISCONNECTION FAULT IN A BACK-UP ELECTRICAL STORE IN AN ON-BOARD ELECTRICAL NETWORK OF AN ELECTRIC VEHICLE

(30) Priorité: 21.02.2022 FR 2201520
(43) Date de publication de la demande: 01.01.2025
(73) Titulaire: Stellantis Auto SAS, 78300 Poissy (FR)
(72) Inventeur: BOTCHON, Yannick, 92160 ANTONY (FR)
(74) Mandataire: PSIP
(86) Numéro de dépôt international: PCT/FR2022/052365
(87) Numéro de publication internationale: WO 2023/156718

(56) Documents cités:
- WO-A1-2016/097551
- FR-A1- 3 001 931
- US-A1- 2015 021 986
- US-A1- 2015 175 027
- US-A1- 2016 069 945

## Description

L'invention se situe de manière générale dans le domaine de la sécurisation énergétique d'un réseau électrique de bord de véhicule électrifié comprenant un stockeur électrique de sécurité. Plus particulièrement, l'invention se rapporte à un procédé de diagnostic d'un défaut de déconnexion d'un stockeur électrique de sécurité dans un réseau électrique de bord d'un véhicule électrifié tel qu'un véhicule tout électrique. L'invention est applicable notamment pour la sécurité de fonctionnement du système de freinage électrique dans un véhicule électrifié.

Dans un véhicule tout électrique, pour garantir la permanence de l'alimentation énergétique des organes sécuritaires par le réseau électrique de bord basse tension, il est connu une architecture de réseau électrique de bord comprenant un stockeur électrique basse tension supplémentaire, dit également ici « stockeur électrique de sécurité », en tant qu'organe auxiliaire du stockeur électrique basse tension principal du réseau électrique de bord. Le stockeur électrique de sécurité assure l'alimentation énergétique des organes sécuritaires du véhicule, tels que le système de freinage électrique, le dispositif de correction électronique de trajectoire, dit correcteur « ESP » pour « Electronic Stability Program » en anglais, la direction assistée électrique et autres, en cas de défaillance du stockeur électrique principal ou d'un convertisseur électrique continu-continu remplissant la fonction de générateur électrique dans le réseau électrique de bord.

L'alimentation électrique des organes sécuritaires doit répondre à des exigences sécuritaires élevées. En effet, par exemple, lors de manœuvres telles qu'un freinage d'urgence, un évitement de collision ou autres, une défaillance de l'alimentation électrique des organes sécuritaires susmentionnés peut conduire à l'occurrence d'un évènement dangereux potentiellement de niveau « D » dans la classification standard « ASIL » (pour "Auto motive Security Integrity Level" en anglais).

Il est donc important en situation de roulage du véhicule de s'assurer que le stockeur électrique de sécurité est bien connecté aux organes sécuritaires, particulièrement au système de freinage électrique, et au réseau électrique de bord pour sa recharge, de façon à garantir la sécurité des personnes et des biens.

En outre, l'état de la technique est connu des documents US2016069945A1, US2015175027A1, WO2016097551 A1, FR3001931A1, US2015021986A1.

Selon un premier aspect, l'invention concerne un procédé de diagnostic d'un défaut de déconnexion d'un stockeur électrique de sécurité inclus dans un réseau électrique de bord basse tension d'un véhicule électrifié, le réseau électrique de bord comprenant également un stockeur électrique principal et un dispositif commutable d'isolation électrique intercalé entre le stockeur électrique de sécurité et le stockeur électrique principal, et le dispositif procurant un couplage/découplage électrique entre des première et deuxième bornes de connexion, reliées respectivement au stockeur électrique de sécurité et au stockeur électrique principal, en fonction d'une commande de couplage/découplage qui lui est appliquée. Conformément à l'invention, le procédé comprend les étapes de A) réaliser une pluralité de mesures de tension au niveau de la première borne de connexion sur une pluralité de roulages du véhicule pendant des phases de découplage entre les première et deuxième bornes de connexion, B) pour chaque dite mesure de tension, détecter un défaut de tension au niveau de la première borne de connexion par comparaison de la mesure de tension à un seuil de tension calibré, et C) décider de l'émission d'un diagnostic de défaut de déconnexion pour le stockeur électrique de sécurité par comparaison d'un nombre compté de défauts de tension sur la pluralité de roulages à un seuil de décision calibré.

Selon une caractéristique particulière du procédé, les défauts de tension comptés sont des défauts de tension détectés successivement sur des phases de découplage successives.

Selon une autre caractéristique particulière du procédé, l'étape A) comprend une seule phase de découplage par roulage.

Selon encore une autre caractéristique particulière, le procédé comprend également une étape D) d'alerter un utilisateur du véhicule lorsqu'un diagnostic de défaut de déconnexion est émis à l'étape C).

Selon encore une autre caractéristique particulière du procédé, l'étape D) comprend l'émission d'une alerte par voyant lumineux et/ou d'une alerte par message audio.

L'invention concerne aussi un calculateur comprenant une mémoire stockant des instructions de programme pour la mise en œuvre du procédé tel que décrit brièvement ci-dessus. Selon une caractéristique particulière, le calculateur est un calculateur superviseur d'un réseau électrique de bord basse tension de véhicule.

L'invention concerne aussi un véhicule électrifié comprenant un réseau électrique de bord basse tension incluant un stockeur électrique principal, un stockeur électrique de sécurité et un dispositif commutable d'isolation électrique intercalé entre le stockeur électrique de sécurité et le stockeur électrique principal, et le dispositif procurant un couplage/découplage électrique entre des première et deuxième bornes de connexion, reliées respectivement au stockeur électrique de sécurité et au stockeur électrique principal, en fonction d'une commande de couplage/découplage qui lui est appliquée, dans lequel est inclus un calculateur comme décrit ci-dessus pour la mise en œuvre du procédé de l'invention. Selon une forme de réalisation, ce véhicule électrifié est de type tout électrique et comprend un système de freinage électrique.

D'autres avantages et caractéristiques de la présente invention apparaîtront plus clairement à la lecture de la description détaillée ci-dessous d'un mode de réalisation particulier de l'invention, en référence aux dessins annexés, dans lesquels :
[Fig.1] La Fig.1 est un bloc-diagramme schématique d'un exemple de véhicule tout électrique ayant un double stockeur électrique basse tension, dans lequel est mis en œuvre le procédé selon la présente invention.
[Fig.2] La Fig.2 est un bloc-diagramme d'un processus de diagnostic d'un défaut de déconnexion d'un stockeur électrique de sécurité, inclus dans le procédé selon la présente invention.
[Fig.3] La Fig.3 est un logigramme d'une première fonction exécutée par le processus de diagnostic de défaut de déconnexion inclus dans le procédé selon la présente invention.
[Fig.4] La Fig.4 est un logigramme d'une deuxième fonction exécutée par le processus de diagnostic de défaut de déconnexion inclus dans le procédé selon la présente invention.
[Fig.5] La Fig.5 est un logigramme d'une troisième fonction exécutée par le processus de diagnostic de défaut de déconnexion inclus dans le procédé selon la présente invention.
[Fig.6] La Fig.6 est un logigramme d'une quatrième fonction exécutée par le processus de diagnostic de défaut de déconnexion inclus dans le procédé selon la présente invention.
[Fig.7] La Fig.7 est un logigramme d'une cinquième fonction exécutée par le processus de diagnostic de défaut de déconnexion inclus dans le procédé selon la présente invention.

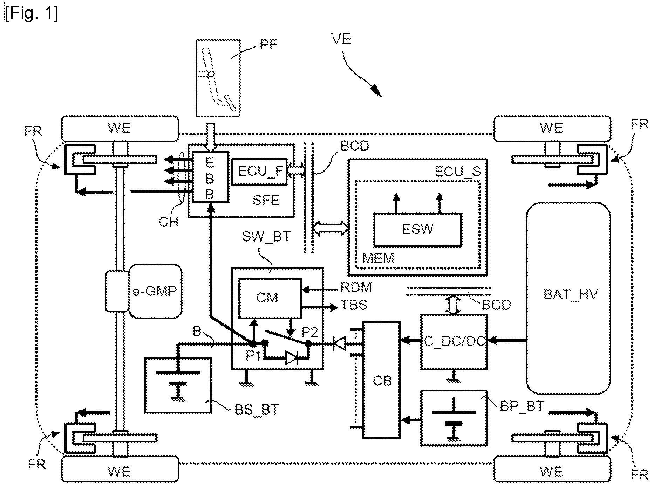

En référence aux Figs.1 à 7, il est maintenant décrit ci-dessous un mode de réalisation particulier du procédé selon l'invention dans le cadre de son application à un véhicule tout électrique équipé d'un système de freinage électrique.

En référence plus particulièrement à Fig.1, le véhicule tout électrique considéré ici, VE, comprend un réseau électrique de bord basse tension ayant une d'architecture à double stockeur électrique. Dans l'exemple d'architecture montré à la Fig.1, le réseau électrique de bord du véhicule VE comprend notamment un stockeur électrique basse tension principal BP_BT, un stockeur électrique basse tension de sécurité BS_BT, un convertisseur électrique continu-continu C_DC/DC, un réseau de câblage électrique CB auquel sont connectés différents consommateurs électriques, un calculateur superviseur ECU_S qui gère le fonctionnement du réseau électrique de bord, ainsi qu'un dispositif commutable d'isolation électrique et de test SW_BT.

Le convertisseur électrique continu-continu C_DC/DC est alimenté en énergie par un stockeur électrique haute tension BAT_HV et assure la fonction de générateur électrique pour le réseau de bord. Le stockeur électrique haute tension BAT_HV fournit à un groupe motopropulseur électrique e-GMP l'énergie électrique nécessaire à la traction du véhicule VE.

Un système de freinage électrique SFE, faisant partie des organes sécuritaires du véhicule VE, est représenté à la Fig.1. Le système de freinage électrique SFE comprend essentiellement un servofrein électrique, dit « EBB » pour « Electric Brake Booster » en anglais, des organes de freinage à la roue FR et un calculateur de commande ECU_F. Le servofrein électrique EBB est actionné par appui sur une pédale de frein PF et commande une pression de freinage dans des circuits hydrauliques de liquide de frein CH qui relient le servofrein électrique EBB aux organes de freinage à la roue FR. Le calculateur de commande ECU_F a pour fonction d'assurer la gestion du système de freinage SFE.

Les calculateurs du véhicule VE, comme les calculateurs ECU_S et ECU_F susmentionnés, le calculateur superviseur de la chaîne de traction électrique (non représenté) et d'autres de différents organes fonctionnels du véhicule, coopèrent entre eux par des échanges d'informations et de commandes via un réseau de communication de données BCD, typiquement de type « CAN ».

Le dispositif commutable d'isolation électrique et de test SW_BT comprend essentiellement des interrupteurs électroniques de puissance, comme des transistors de type « MOSFET », et des moyens de commande et de mesure de tension CM.

Le dispositif SW_BT est monté intercalé entre le stockeur électrique de sécurité BS_BT alimentant les organes sécuritaires, représentés ici par le système de freinage électrique SFE, et le reste du réseau électrique de bord qui inclut le stockeur électrique principal BP_BT, le convertisseur C_DC/DC et des consommateurs électriques. Le dispositif SW_BT procure des première et deuxième bornes de connexion P1 et P2, en connexion électrique ou pas selon l'état de commutation du dispositif SW_BT. La première borne P1 est destinée au raccordement au dispositif SW_BT du stockeur électrique de sécurité BS_BT et du système de freinage électrique SFE. La deuxième borne P2 est destinée au raccordement du dispositif SW_BT au reste du réseau électrique de bord.

Le dispositif SW_BT permet donc un couplage/découplage électrique du stockeur électrique de sécurité BS_BT par rapport au reste du réseau électrique de bord et, en particulier, par rapport au stockeur électrique principal BP_BT et au convertisseur C_DC/DC.

Lorsque le dispositif SW_BT est fermé, le stockeur électrique de sécurité BS_BT est chargé par le convertisseur électrique C_DC/DC faisant office de générateur électrique du réseau électrique de bord.

Grâce au dispositif SW_BT, le stockeur électrique de sécurité BS_BT, en restant connecté au système de freinage électrique SFE pour son alimentation électrique, peut ainsi être isolé électriquement du réseau électrique de bord afin de réaliser des tests et de vérifier sa capacité à répondre aux besoins sécuritaires du véhicule VE.

Dans le dispositif SW_BT, les moyens de commande et de mesure de tension CM comprennent typiquement une interface de communication (non représentée) avec le réseau de communication de données BCD, qui reçoit en entrée une requête de découplage et mesure RDM et qui délivre en sortie une information de tension TBS représentative de la tension mesurée au niveau de la borne de connexion P1 à laquelle est raccordé le stockeur BS_BT. La requête de découplage et mesure RDM commande l'ouverture du dispositif SW_BT et la mesure de la tension sur la borne P1. L'information de tension TBS fournie par les moyens CM est exploitée par le procédé de l'invention pour diagnostiquer un éventuel défaut de déconnexion du stockeur électrique de sécurité BS_BT au niveau du tronçon de raccordement électrique B avec la première borne de connexion P1 du dispositif SW_BT et/ou au niveau de son raccordement à la masse du véhicule VE. Lorsque le dispositif SW_BT est ouvert, si le stockeur BS_BT est correctement raccordé à ce dernier, la tension TBS mesurée sur la borne P1 sera sensiblement égale à la tension de service du stockeur, soit typiquement 12 V. Une tension TBS substantiellement inférieure au niveau normal attendu est révélatrice d'un possible défaut de déconnexion du stockeur BS_BT. Pour ce diagnostic sur un possible défaut de déconnexion du stockeur BS_BT, le dispositif SW_BT doit être ouvert, pour éviter une mesure fausse sur la borne P1 qui serait due à la tension de service imposée sur le réseau de bord par le convertisseur C_DC/DC et le stockeur électrique principal BP_BT.

Le procédé selon l'invention est mis en œuvre au moyen d'un module logiciel embarqué ESW. Le module logiciel embarqué ESW est implanté ici dans une mémoire MEM du calculateur superviseur ECU_S du réseau électrique de bord. Le calculateur superviseur ECU_S pourra être amené à coopérer, sous la supervision du module logiciel ESW, avec d'autres calculateurs du véhicule VE pour la mise en œuvre du procédé de l'invention. Dans d'autres modes de réalisation, le module logiciel ESW pourra être hébergé dans un autre calculateur du véhicule, comme par exemple le calculateur superviseur de la chaîne de traction électrique susmentionné.

Le module logiciel ESW autorise la mise en œuvre du procédé selon l'invention par l'exécution d'instructions de code de programme par un processeur (non représenté) du calculateur superviseur ECU_S.

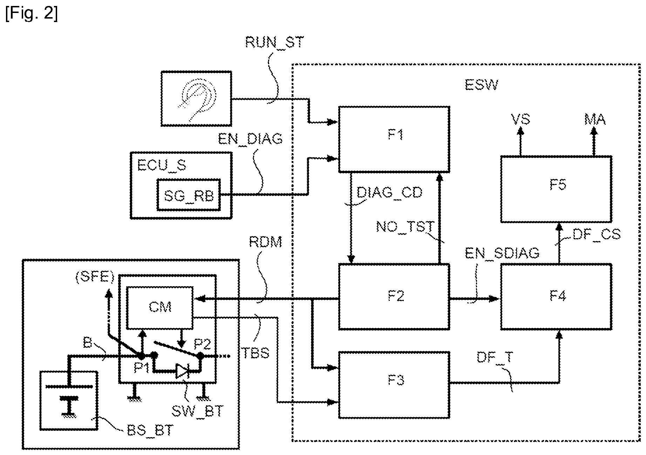

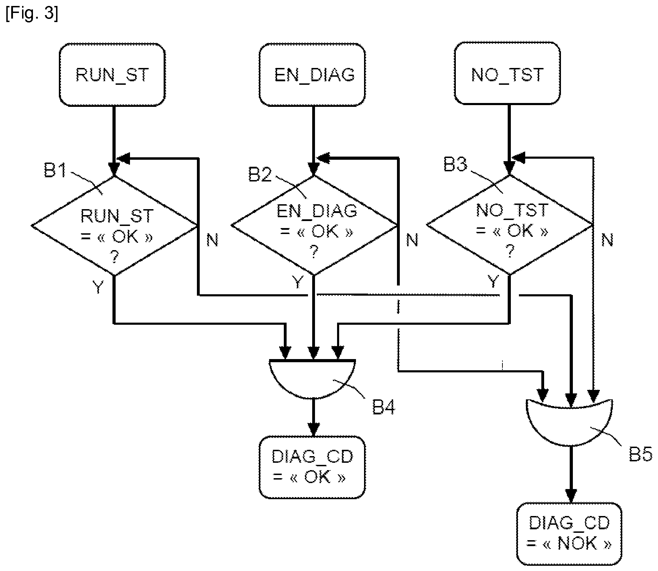

Le module logiciel ESW diagnostique un défaut de déconnexion du stockeur électrique de sécurité BS_BT à l'aide d'un processus de diagnostic comprenant essentiellement cinq fonctions F1 à F5. Les fonctions F1 à F5 sont décrites en détail ci-dessous en référence aux Figs.2 à 7. Dans les logigrammes des Figs.3 à 7, une condition satisfaite, une commande active ou une information vraie est représentée par l'état « OK », alors qu'une condition non-satisfaite, une commande inactive ou une information fausse est représentée par l'état « NOK ».

De manière générale, le diagnostic de déconnexion du stockeur électrique de sécurité BS_BT est réalisé à partir de l'information de tension TBS susmentionnée. Pendant des phases de diagnostic de défaut de tension où le dispositif SW_BT est ouvert, un défaut de tension sur la borne P1 est détecté en comparant l'information de tension TBS provenant de la mesure à un seuil de tension calibré. Un comptage des défauts de tension détectés est réalisé pour confirmer le diagnostic d'un défaut de déconnexion du stockeur électrique de sécurité BS_BT. L'utilisateur est alerté lorsqu'un diagnostic de défaut de déconnexion du stockeur électrique de sécurité BS_BT est confirmé.

Dans le mode de réalisation particulier considéré ici, le diagnostic de défaut de tension est réalisé une seule fois par roulage, dans une phase où le véhicule a été démarré par l'utilisateur et est prêt à rouler ou est déjà en train de rouler. La réalisation du diagnostic de défaut de tension une seule fois par roulage permet de minimiser la possibilité qu'une phase de freinage intervienne pendant ce diagnostic. En effet, pendant le diagnostic de défaut de tension, le dispositif SW_BT étant ouvert, le système de freinage électrique SFE n'est alimenté que par le stockeur électrique de sécurité BS_BT et ne bénéficie donc pas du support du convertisseur C_DC/DC en tant que générateur électrique du réseau de bord.

En référence aux Figs.2 et 3, la fonction F1 est chargée d'initier un processus de diagnostic de défaut de tension du stockeur électrique de sécurité BS_BT à chaque nouveau roulage du véhicule VE. Pour cela, la fonction F1 vérifie tout d'abord la satisfaction de certaines conditions préalables, avant d'autoriser le lancement du processus. Les conditions préalables comprennent notamment ici 1) la détection d'un roulage du véhicule VE représentée par une information d'entrée RUN_ST, 2) une autorisation de diagnostic représentée par une information d'entrée EN_DIAG, délivrée par une stratégie de gestion SG_RB du réseau électrique de bord qui est hébergée typiquement dans le calculateur superviseur ECU_S et 3) l'absence d'un précédent diagnostic, déjà réalisé pendant le roulage considéré ou en cours, représentée par une information d'entrée NO_TST, pour ne pas relancer le processus de diagnostic de défaut de tension pendant un même roulage.

Comme visible dans le logigramme de la Fig.3, des blocs fonctionnels B1 à B5 coopèrent pour vérifier les conditions RUN_ST, EN_DIAG et NO_TST et délivrer une commande d'exécution de diagnostic de défaut de tension DIAG_CD.

Le bloc fonctionnel B1 (B2 ou B3) active une sortie Y lorsque la condition RUN_ST (EN_DIAG ou NO_TST) est satisfaite (« OK ») et active une sortie N lorsque la condition RUN_ST (EN_DIAG ou NO_TST) n'est pas satisfaite (« NOK »). Une fonction logique de type « ET », B4, délivre la commande d'exécution de diagnostic valide, DIAG_CD= « OK », lorsque les trois sorties « Y » des blocs fonctionnels B1 à B3 sont actives. Une fonction logique de type « OU », B5, délivre la commande d'exécution de diagnostic invalide, DIAG_CD= « NOK », lorsqu'au moins une des trois sorties « N » des blocs fonctionnels B1 à B3 est active.

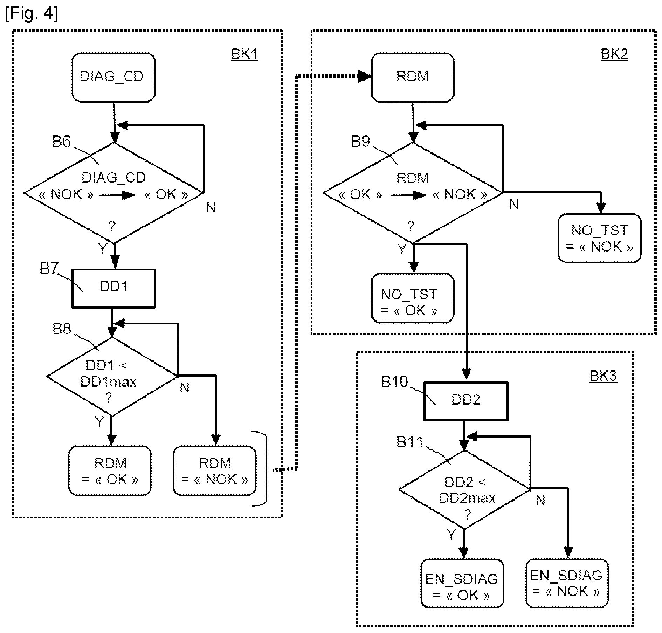

En référence maintenant plus particulièrement aux Figs.2 et 4, la fonction F2 est chargée, lorsque le processus de diagnostic de défaut de tension du stockeur électrique de sécurité BS_BT est initié, de piloter le dispositif SW_BT pour découpler le stockeur électrique de sécurité BS_BT du reste du réseau de bord, de façon à mesurer valablement la tension sur la borne P1 et de renseigner l'information de tension susmentionnée TBS. La fonction F2 fournit aussi une autorisation pour une synthèse de confirmation de défaut de déconnexion.

La fonction F2 reçoit en entrée la commande d'exécution de diagnostic de défaut de tension DIAG_CD et fournit en sortie la requête de découplage et mesure RDM, l'information d'absence d'un précédent diagnostic NO_TST, traitée par la fonction F1 comme décrit plus haut, et une autorisation de synthèse de diagnostic EN_SDIAG.

Comme visible dans le logigramme de la Fig.4, la fonction F2 comporte trois sous-fonctions BK1 à BK3 qui sont exécutées successivement.

La sous-fonction BK1 traite en entrée la commande d'exécution de diagnostic de défaut de tension DIAG_CD et délivre en sortie la requête de découplage et mesure RDM. Un bloc fonctionnel B6 est chargé de détecter une transition de la commande d'exécution de diagnostic de défaut de tension DIAG_CD de l'état invalide DIAG_CD = « NOK » à l'état valide DIAG_CD = « OK ». Le bloc fonctionnel B6 active une sortie Y lorsque cette transition est détectée, et lance consécutivement le comptage d'une durée de découplage DD1 par un bloc fonctionnel B7. La durée DD1 est la durée écoulée depuis le début de l'ouverture du dispositif SW_BT, autrement dit, la durée écoulée depuis le début du découplage entre le stockeur électrique de sécurité BS_BT et le reste du réseau de de bord. Une durée de découplage maximum DD1max est calibrée, typiquement à une seconde environ. Un bloc fonctionnel B8 commande les transitions de la requête de découplage et mesure RDM entre son état valide RDM = « OK », qui commande l'ouverture du dispositif SW_BT, et son état invalide RDM = « NOK », qui commande la fermeture du dispositif SW_BT. L'état valide RDM = « OK » de la requête de découplage et mesure RDM est activé par une sortie Y du bloc B8 tant que la durée de découplage DD1 reste inférieure à la durée de découplage maximum DD1max. Lorsque la durée de découplage DD1 atteint la durée de découplage maximum DD1max, une sortie N du bloc B8 est activée et provoque une transition de la requête de découplage et mesure RDM vers son état invalide RDM = « NOK ».

La sous-fonction BK2 détecte, au moyen du bloc fonctionnel B9, une fermeture du dispositif SW_BT intervenant après une ouverture de celui-ci, par la transition de la requête de découplage et mesure RDM de son état valide RDM = « OK » à son état invalide RDM = « NOK ». La sous-fonction BK2 produit ainsi l'information susmentionnée NO_TST exploitée par la fonction F1 et qui indique la fin d'un processus de diagnostic de défaut de tension. Ainsi, lorsque la transition de la requête RDM de RDM = « OK » vers RDM = « NOK » est détectée par le bloc fonctionnel B9, une sortie Y de celui-ci est activée et détermine NO_TST = « OK ». Dans le cas contraire où la requête RDM reste à son état valide RDM = « OK », c'est une sortie N du bloc fonctionnel B9 qui est activée et qui détermine consécutivement NO_TST = « NOK ».

La sous-fonction BK3 est chargée de générer l'autorisation de synthèse de diagnostic EN_SDIAG. L'autorisation de synthèse de diagnostic EN_SDIAG commute à son état valide EN_SDIAG = « OK » sur la détection par le bloc fonctionnel B9 de la transition de la requête de découplage et mesure RDM de son état valide RDM = « OK » à son état invalide RDM = « NOK ». L'autorisation de synthèse de diagnostic EN_SDIAG reste valide, EN_SDIAG = « OK », pendant une durée de validité calibrée DD2max, typiquement de l'ordre d'une centaine de microsecondes. Les blocs fonctionnels B10 et B11 permettent de produire l'autorisation de synthèse de diagnostic EN_SDIAG avec cette durée de validité calibrée DD2max. Un comptage d'une durée DD2 est lancée par le bloc fonctionnel B10 dès l'activation à l'état valide, EN_SDIAG = « OK », de l'autorisation de synthèse de diagnostic EN_SDIAG. Le bloc fonctionnel B11 compare la durée comptée DD2 à la durée de validité calibrée DD2max. L'état valide EN_SDIAG = « OK » de l'autorisation de synthèse de diagnostic EN_SDIAG est maintenu par une sortie Y du bloc B11 tant que la durée comptée DD1 reste inférieure à la durée de découplage maximum DD1max. Lorsque la durée comptée DD2 atteint la durée de validité calibrée DD2max, une sortie N du bloc B11 est activée et provoque une transition de l'autorisation de synthèse de diagnostic EN_SDIAG vers son état invalide EN_SDIAG = « NOK ».

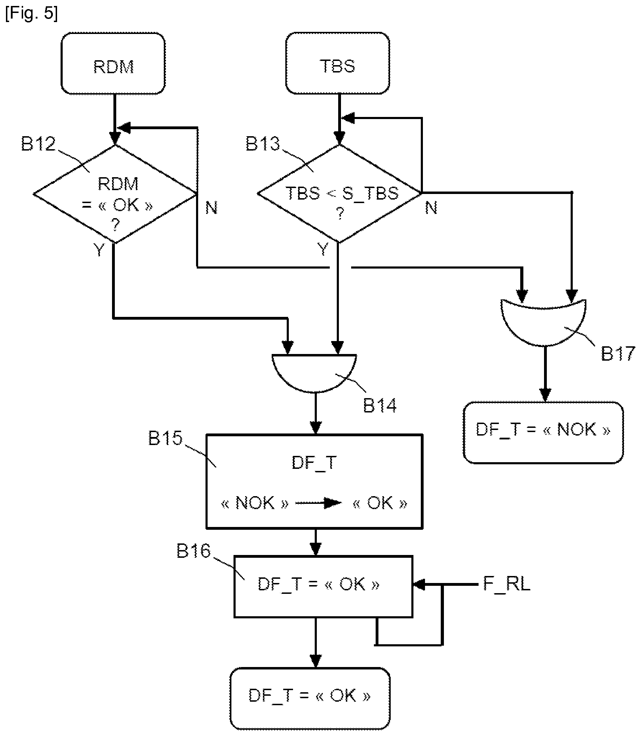

En référence maintenant plus particulièrement aux Figs.2 et 5, la fonction F3 est chargée de détecter un défaut de tension sur la borne P1 à partir de l'information de tension TBS représentative de la mesure de tension effectuée pendant le découplage entre le stockeur électrique de sécurité BS_BT et le reste du réseau électrique de bord. La fonction F3 permet de détecter tout comportement caractéristique de la tension mesurée qui résulterait d'une déconnexion physique du stockeur électrique de sécurité BS_BT, typiquement un niveau très faible ou nul de cette tension mesurée.

La fonction F3 reçoit en entrée la requête de découplage et mesure RDM et l'information de tension TBS et délivre en sortie une information de défaut de tension DF_T. La requête de déconnexion et mesure active, RDM = « OK », valide l'information de tension TBS fournie par le dispositif SW_BT comme correspondant à une mesure de tension valable sur la borne P1, c'est-à-dire, une mesure de tension représentative qui, pendant un découplage, n'est pas faussée par la tension de service imposée sur le réseau de bord par le convertisseur C_DC/DC et le stockeur électrique principal BP_BT.

Comme visible dans le logigramme de la Fig.5, des blocs fonctionnels B12 à B16 coopèrent pour produire l'information de défaut de tension DF_T.

Le bloc fonctionnel B12 vérifie l'état de la requête de découplage et mesure RDM. Le bloc fonctionnel B12 active une sortie Y lorsque la requête RDM est valide, RDM = « OK », et active une sortie N lorsque la requête RDM est invalide, RDM = « NOK ».

Le bloc fonctionnel B13 compare la mesure de tension donnée par l'information TBS à un seuil de tension calibré S_TBS, de façon à détecter un éventuel défaut de tension DF_T. Le seuil de tension calibré a, par exemple, une valeur de 5 V. Le bloc fonctionnel B13 active une sortie Y lorsque la mesure de tension TBS est inférieure au seuil de tension calibré S_TBS et active une sortie N dans le cas contraire.

Une fonction logique de type « ET », B14, indique la détection effective d'un défaut de tension lorsque les deux sorties « Y » des blocs fonctionnels B12 à B13 sont actives. Dans le bloc fonctionnel B15, la détection d'un défaut de tension par la fonction logique B14 commande une transition de l'information de défaut de tension DF_T de l'état invalide DF_T = « NOK » à l'état valide DF_T = « OK ». Le bloc fonctionnel B16 maintient ensuite l'information de défaut de tension DF_T à son état valide DF_T = « OK » jusqu'à la fin du roulage en cours qui est indiquée par une information F_RL.

Une fonction logique de type « OU », B17, indique la non-détection d'un défaut de tension, DF_T = « NOK », lorsqu'au moins une des deux sorties « N » des blocs fonctionnels B1 à B3 est active.

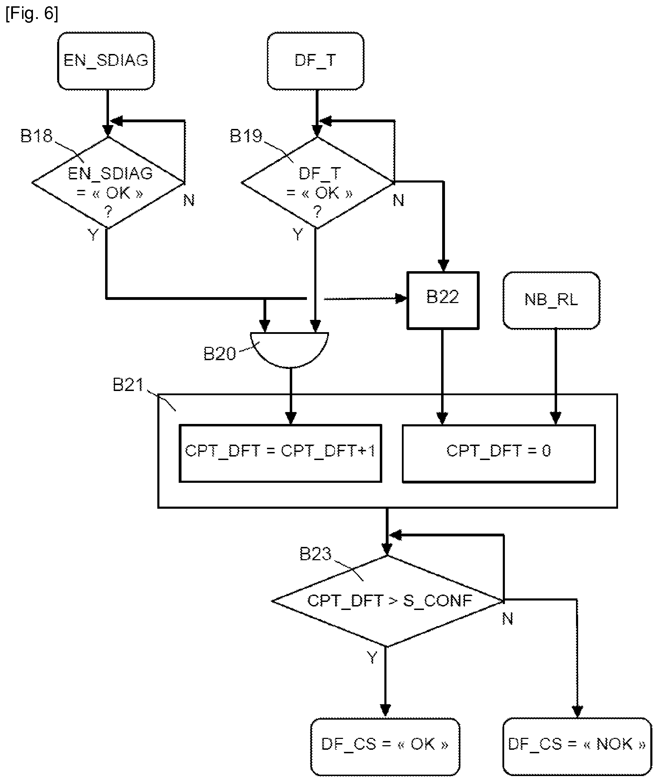

En référence maintenant plus particulièrement aux Figs.2 et 6, la fonction F4 confirme un diagnostic d'un défaut de déconnexion DF_CS du stockeur électrique de sécurité BS_BT à partir d'une synthèse des défauts de tension DF_T détectés sur un nombre calibré NB_RL de roulages successifs effectués par le véhicule VE. Pour cela, la fonction F4 assure un comptage et une mémorisation du nombre de défauts de tension DF_T détectés sur le nombre calibré de roulages successifs NB_RL et décide de la présence effective d'un défaut de déconnexion, DF_CS = « OK », lorsque le nombre CPT_DFT de défauts de tension DF_T atteint un seuil de décision calibré S_CONF.

Comme visible dans le logigramme de la Fig.6, des blocs fonctionnels B18 à B23 coopèrent pour produire l'information de défaut de déconnexion DF_CS.

Le bloc fonctionnel B18 vérifie l'état de l'autorisation de synthèse de diagnostic EN_SDIAG. Le bloc fonctionnel B18 active une sortie Y lorsque l'autorisation EN_SDIAG est valide, EN_SDIAG = « OK », et active une sortie N lorsque l'autorisation EN_SDIAG est invalide, EN_SDIAG = « NOK ».

Le bloc fonctionnel B19 vérifie l'état de l'information de défaut de tension DF_T. Le bloc fonctionnel B19 active une sortie Y lorsque l'information DF_T est valide, DF_T = « OK », et active une sortie N lorsque l'information DF_T est invalide, DF_T = « NOK ».

Une fonction logique de type « ET », B20, reçoit en entrée les deux sorties « Y » des blocs fonctionnels B18 à B19 et commande un bloc fonctionnel B21 qui est un compteur du nombre CPT_DFT de défauts de tension DF_T. Lorsque les deux sorties « Y » des blocs fonctionnels B18 à B19 sont actives, le compteur B21 est incrémenté d'une unité, CPT_DFT = CPT_DFT +1. La valeur incrémentée du nombre CPT_DFT est ensuite maintenue constante jusqu'au diagnostic de défaut de tension suivant qui interviendra lors du prochain roulage, une seule détection de défaut de tension étant autorisée par roulage dans ce mode de réalisation particulier, comme indiqué plus haut dans la description.

Le bloc fonctionnel B22 est chargé de détecter l'absence de défaut de tension, DF_T = « NOK », pendant toute la durée du diagnostic de défaut de tension, correspondant à EN_SDIAG = « OK ». Le bloc fonctionnel B22 réalise sa détection à partir de la sortie « Y » du bloc fonctionnel B18 et de la sortie « N » du bloc fonctionnel B19, et remet à zéro le compteur B21, CPT_DFT = 0, lorsque la détection d'absence de défaut de tension est effective. Compte-tenu de la remise à zéro du compteur B21 effectué par le bloc fonctionnel B22, le nombre CPT_DFT indique un nombre de détections valides successives du défaut de tension sur des roulages successifs.

Le compteur B21 est également remis à zéro, CPT_DFT = 0, lorsqu'est atteint le nombre calibré de roulages successifs NB_RL.

Le bloc fonctionnel B23 compare le nombre CPT_DFT de défauts de tension donné par le compteur B21 au seuil de décision calibré S_CONF. Lorsque nombre CPT_DFT atteint le seuil de décision calibré S_CONF, CPT_DFT > S_CONF, la sortie Y du bloc fonctionnel B23 est activée et valide, DF_CS = « OK », un diagnostic de défaut de déconnexion du stockeur électrique de sécurité BS_BT. Dans le cas contraire, c'est la sortie N du bloc fonctionnel B23 qui est activée et celle-ci indique une absence de détection, DF_CS = « NOK », d'un défaut de déconnexion du stockeur électrique de sécurité BS_BT.

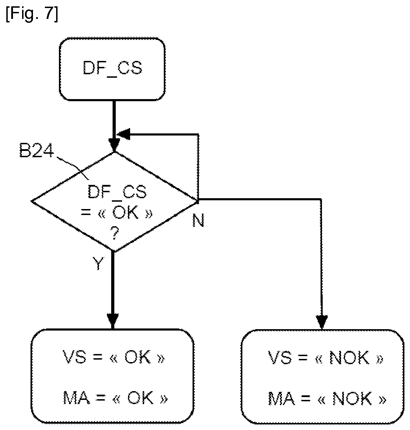

En référence maintenant plus particulièrement aux Figs.2 et 7, la fonction F5 assure une gestion d'alertes vers l'utilisateur lorsqu'un défaut de déconnexion du stockeur électrique de sécurité BS_BT a été confirmé, DF_CS = « OK », par la fonction F4.

Comme visible dans le logigramme de la Fig.7, un bloc fonctionnel B24 assure la gestion d'une ou plusieurs d'alertes, comme VS et/ou MA, à partir de l'information de défaut de déconnexion DF_CS. Lorsque l'information DF_CS indique un défaut de déconnexion valide, DF_CS = « OK », la sortie Y du bloc fonctionnel B24 est activée et commande l'émission des alertes VS= « OK » et/ou MA = « OK », par exemple, sous la forme d'un signal lumineux (voyant) et/ou d'un message audio. Dans le cas contraire, c'est la sortie N du bloc fonctionnel B24 qui est activée et aucune alerte n'est émise, VS= « NOK » et MA = « NOK ».

De manière générale, la présente invention permet un niveau de sécurisation élevé du réseau électrique de bord basse tension dans un véhicule muni d'une architecture électrique à double stockeur électrique basse tension. Elle autorise une meilleure maitrise des problématiques de sécurisation électrique sur le réseau de bord pour garantir l'alimentation électrique des organes sécuritaires.

## Revendications

1. Procédé de diagnostic d'un défaut de déconnexion d'un stockeur électrique de sécurité (BS_BT) inclus dans un réseau électrique de bord basse tension d'un véhicule électrifié (VE), ledit réseau électrique de bord comprenant également un stockeur électrique principal (BP_BT) et un dispositif commutable d'isolation électrique (SW_BT) intercalé entre ledit stockeur électrique de sécurité (BS_BT) et ledit stockeur électrique principal (BP_BT), et ledit dispositif (SW_BT) procurant un couplage/découplage électrique entre des première et deuxième bornes de connexion (P1, P2), reliées respectivement auxdits stockeur électrique de sécurité et stockeur électrique principal (BS_BT, BP_BT), en fonction d'une commande de couplage/découplage (RDM) qui lui est appliquée, edit procédé comprenant les étapes de A) réaliser (F1, F2) une pluralité de mesures de tension (TBS) au niveau de ladite première borne de connexion (P1) sur une pluralité de roulages dudit véhicule (VE) pendant des phases de découplage entre lesdites première et deuxième bornes de connexion (P1, P2), B) pour chaque dite mesure de tension (TBS), détecter (F3) un défaut de tension (DF_T) au niveau de ladite première borne de connexion (P1) par comparaison de ladite mesure de tension (TBS) à un seuil de tension calibré (S_TBS), et C) décider (F4) de l'émission d'un diagnostic de défaut de déconnexion (DF_CS) pour ledit stockeur électrique de sécurité (BS_BT) par comparaison d'un nombre compté de défauts de tension (CPT_DF) sur ladite pluralité de roulages à un seuil de décision calibré (S_CONF).

2. Procédé selon la revendication 1, **caractérisé en ce que**, à l'étape C), lesdits défauts de tension comptés (CPT_DFT) sont des défauts de tension détectés successivement (B20, B21, B22) sur des phases de découplage successives.

3. Procédé selon la revendication 1 ou 2, **caractérisé en ce que** l'étape A) comprend une seule phase de découplage par roulage (F1, NO_TST).

4. Procédé selon l'une quelconque des revendication 1 à 3, **caractérisé en ce qu'**il comprend également une étape D) d'alerter (F5) un utilisateur dudit véhicule (VE) lorsqu'un dit diagnostic de défaut de déconnexion (DF_CS) est émis à l'étape C).

5. Procédé selon la revendication 4, **caractérisé en ce que** l'étape D) comprend l'émission d'une alerte par voyant lumineux (VS) et/ou d'une alerte par message audio (MA).

6. Calculateur (ECU_S) **caractérisé en ce qu'**il comprend une mémoire (MEM) stockant des instructions de programme (ESW) pour la mise en œuvre du procédé selon l'une quelconque des revendications 1 à 5.

7. Calculateur selon la revendication 6, **caractérisé en ce qu'**il est formé par un calculateur superviseur (ECU_S) d'un réseau électrique de bord basse tension de véhicule.

8. Véhicule électrifié (VE) comprenant un réseau électrique de bord basse tension incluant un stockeur électrique principal (BP_BT), un stockeur électrique de sécurité (BS_BT) et un dispositif commutable d'isolation électrique (SW_BT) intercalé entre ledit stockeur électrique de sécurité (BS_BT) et ledit stockeur électrique principal (BP_BT), et ledit dispositif (SW_BT) procurant un couplage/découplage électrique entre des première et deuxième bornes de connexion (P1, P2), reliées respectivement auxdits stockeur électrique de sécurité et stockeur électrique principal (BS BT, BP BT), en fonction d'une commande de couplage/découplage (RDM) qui lui est appliquée, **caractérisé en ce qu'**il comprend également un calculateur (ECU_S) selon la revendication 6 ou 7.

9. Véhicule électrifié selon la revendication 8, **caractérisé en ce qu'**il est de type tout électrique (VE) et comprend un système de freinage électrique (SFE).

## Patentansprüche

1. Verfahren zur Diagnose eines Trennungsfehlers eines elektrischen Sicherheitsspeichers (BS_BT), der in einem Niederspannungs-Bordnetz eines Elektrofahrzeugs (VE) enthalten ist, wobei das Bordnetz außerdem einen elektrischen Hauptspeicher (BP_BT) und eine schaltbare elektrische Trennvorrichtung (SW_BT) umfasst, die zwischen dem elektrischen Sicherheitsspeicher (BS_BT) und dem elektrischen Hauptspeicher (BP_BT) angeordnet ist, und wobei die Vorrichtung (SW_BT) eine elektrische Kopplung/Entkopplung zwischen ersten und zweiten Anschlussklemmen (P1, P2) bereitstellt, die jeweils mit dem elektrischen Sicherheitsspeicher und dem elektrischen Hauptspeicher (BS_BT, BP_BT) verbunden sind, als Funktion eines darauf angewendeten Kopplungs-/Entkopplungsbefehls (RDM), wobei das Verfahren die Schritte umfasst: A) Durchführen (F1, F2) einer Vielzahl von Spannungsmessungen (TBS) an der ersten Anschlussklemme (P1) auf einer Vielzahl von Strecken des Fahrzeugs (VE) während Entkopplungsphasen zwischen den ersten und zweiten Anschlussklemmen (P1, P2), B) für jede der Spannungsmessung (TBS), Erkennen (F3) eines Spannungsfehlers (DF_T) an der ersten Anschlussklemme (P1) durch Vergleichen der Spannungsmessung (TBS) mit einem kalibrierten Spannungsschwellenwert (S_TBS) und C) Entscheiden (F4) über die Ausgabe einer Abschaltfehlerdiagnose (DF_CS) für den Sicherheitsstromspeicher (BS_BT) durch Vergleichen der gezählten Anzahl von Spannungsfehlern (CPT_DF) in den mehreren Durchläufen mit einem kalibrierten Entscheidungsschwellenwert (S_CONF).

2. Verfahren nach Anspruch 1, **dadurch gekennzeichnet, dass** in Schritt C) die gezählten Spannungsfehler (CPT_DFT) Spannungsfehler sind, die nacheinander (B20, B21, B22) in aufeinanderfolgenden Entkopplungsphasen erkannt wurden.

3. Verfahren nach Anspruch 1 oder 2, **dadurch gekennzeichnet, dass** Schritt A) eine einzelne rollierende Entkopplungsphase (F1, NO_TST) umfasst.

4. Verfahren nach einem der Ansprüche 1 bis 3, **dadurch gekennzeichnet, dass** es zusätzlich einen Schritt D) umfasst, in dem ein Benutzer des Fahrzeugs (VE) gewarnt wird (F5), wenn in Schritt C) eine Trennungsfehlerdiagnose (DF_CS) ausgegeben wird.

5. Verfahren nach Anspruch 4, **dadurch gekennzeichnet, dass** Schritt D) die Ausgabe einer Warnung per Kontrollleuchte (VS) und/oder einer Warnung per Audionachricht (MA) umfasst.

6. Computer (ECU_S), **dadurch gekennzeichnet, dass** er einen Speicher (MEM) mit Programmanweisungen (ESW) zur Durchführung des Verfahrens nach einem der Ansprüche 1 bis 5 umfasst.

7. Computer nach Anspruch 6, **dadurch gekennzeichnet, dass** er von einem Überwachungscomputer (ECU_S) eines Niederspannungs-Bordnetzes eines Fahrzeugs gebildet wird.

8. Elektrofahrzeug (VE) mit einem Niederspannungs-Bordnetz, das einen Hauptstromspeicher (BP_BT), einen Sicherheitsstromspeicher (BS_BT) und eine zwischen dem Sicherheitsstromspeicher (BS_BT) und dem Hauptstromspeicher (BP_BT) angeordnete schaltbare elektrische Trennvorrichtung (SW_BT) umfasst, wobei die Vorrichtung (SW_BT) eine elektrische Kopplung/Entkopplung zwischen ersten und zweiten Anschlussklemmen (P1, P2) ermöglicht, die jeweils mit dem Sicherheitsstromspeicher und dem Hauptstromspeicher (BS_BT, BP_BT) verbunden sind, entsprechend einem darauf angewendeten Kopplungs- /Entkopplungsbefehl (RDM), **dadurch gekennzeichnet, dass** es außerdem einen Computer (ECU_S) gemäß Anspruch 6 oder 7 umfasst.

9. Elektrofahrzeug nach Anspruch 8, **dadurch gekennzeichnet, dass** es ein vollelektrisches Fahrzeug (VE) ist und ein elektrisches Bremssystem (SFE) umfasst.

## Claims

1. Method for diagnosing a disconnection fault of a safety electrical storage device (BS_BT) included in a low-voltage on-board electrical network of an electrified vehicle (VE), said on-board electrical network also comprising a main electrical storage device (BP_BT) and a switchable electrical isolation device (SW_BT) interposed between said safety electrical storage device (BS_BT) and said main electrical storage device (BP_BT), and said device (SW_BT) providing electrical coupling/decoupling between first and second connection terminals (P1, P2), respectively connected to said safety electrical storage device and main electrical storage device (BS_BT, BP_BT), as a function of a coupling/decoupling command (RDM) applied thereto, said method comprising the steps of A) carrying out (F1, F2) a plurality of voltage measurements (TBS) at said first connection terminal (P1) on a plurality of runs of said vehicle (VE) during decoupling phases between said first and second connection terminals (P1, P2), B) for each said voltage measurement (TBS), detecting (F3) a voltage fault (DF_T) at said first connection terminal (P1) by comparing said voltage measurement (TBS) with a calibrated voltage threshold (S_TBS), and C) deciding (F4) to issue a disconnection fault diagnosis (DF_CS) for said safety electrical storage device (BS_BT) by comparing a counted number of voltage faults (CPT_DF) on said plurality of runs with a calibrated decision threshold (S_CONF).

2. Method according to claim 1, **characterized in that**, in step C), said counted voltage faults (CPT_DFT) are voltage faults detected successively (B20, B21, B22) on successive decoupling phases. C

3. Method according to claim 1 or 2, **characterized in that** step A) comprises a single rolling decoupling phase (F1, NO_TST).

4. Method according to any one of claims 1 to 3, **characterized in that** it also comprises a step D) of alerting (F5) a user of said vehicle (VE) when a said disconnection fault diagnosis (DF_CS) is issued in step C).

5. Method according to claim 4, **characterized in that** step D) comprises the emission of an alert by indicator light (VS) and/or an alert by audio message (MA).

6. Computer (ECU_S) **characterized in that** it comprises a memory (MEM) storing program instructions (ESW) for implementing the method according to any one of claims 1 to 5.

7. Computer according to claim 6, **characterized in that** it is formed by a supervisor computer (ECU_S) of a low-voltage on-board electrical network of a vehicle.

8. Electrified vehicle (VE) comprising a low-voltage on-board electrical network including a main electrical storage device (BP_BT), a safety electrical storage device (BS_BT) and a switchable electrical isolation device (SW_BT) interposed between said safety electrical storage device (BS_BT) and said main electrical storage device (BP_BT), and said device (SW_BT) providing electrical coupling/decoupling between first and second connection terminals (P1, P2), connected respectively to said safety electrical storage device and main electrical storage device (BS_BT, BP_BT), according to a coupling/decoupling command (RDM) applied thereto, **characterized in that** it also comprises a computer (ECU_S) according to claim 6 or 7.

9. Electrified vehicle according to claim 8, **characterized in that** it is of the all-electric type (VE) and comprises an electric braking system (SFE).
